Europäisches Patentamt

European Patent Office

Office européen des brevets

(11) Publication number: **0 150 928**
A2

# (12) EUROPEAN PATENT APPLICATION

(21) Application number: **85300149.3**

(22) Date of filing: **09.01.85**

(51) Int. Cl.⁴: **H 05 K 7/10, H 01 R 9/09, H 01 R 43/02**

(30) Priority: **30.01.84 US 575100**
**14.11.84 US 671365**

(43) Date of publication of application: **07.08.85**
**Bulletin 85/32**

(84) Designated Contracting States: **BE DE FR GB IT NL**

(71) Applicant: **AMP INCORPORATED, P.O. Box 3608 449 Eisenhower Boulevard, Harrisburg Pennsylvania 17105 (US)**

(72) Inventor: **Pauza, William Vito, R.D. No. 2 Box 82, Palmyra Pennsylvania 17078 (US)**

(74) Representative: **Gray, Robin Oliver et al, BARON & WARREN 18 South End Kensington, London W8 5BU (GB)**

(54) A compliant interconnection device and assembly method of manufacture, and of micro interconnection casting.

㉗ There is disclosed a method for mounting chip carriers (26) on a printed circuit board (27); a method for preparing a compliant cast solder device (25a) as means for mounting the chip carriers (26) on the circuit board (27); a combination of a chip carrier (26) with a circuit board (27) secured by the disclosed means (25a) for mounting, securing, and electrically connecting the chip carriers (26), and a method of microinterconnection casting. Interconnections (31) extend on both sides of a plate and are formed as precision cast, relatively high temperature eutectic tin-lead alloy as cast columns (31c, 31d) lockingly engaged with the plate (25).

"A COMPLIANT INTERCONNECTION DEVICE AND ASSEMBLY,
METHOD OF MANUFACTURE, AND OF MICRO INTERCONNECTION CASTING"

This invention relates to an improved method for preparing a device for securing carriers for integrated circuit elements (conventionally called "chips") to a circuit device, such as a printed circuit board (conventionally called "PCB"). More particularly, this invention relates to a device prepared for mounting large leadless chip carriers (conventionally called LCC's") to circuit boards of any kind of a material having a thermal coefficient of expansion (TCE) different from the TCE of the chip carrier, or for securing an LCC to a PCB where either undergoes a varying induced temperature difference or is exposed to a thermal gradient by virtue of the location of a heat source. Still further, this invention pertains to the method for preparing the device for mounting the chip carriers to a circuit board having predictable and improved ability to accommodate stresses associated with in-use or accelerated temperature cycling, vibration and/or flexing. Additionally, this invention pertains to the combination of the chip and chip carrier secured by the device for mounting the chip carrier to the circuit board and also the combination of the secured chip carrier to the printed circuit board.

Still further and as another feature of the disclosed device, it predictably improves performance affected by especially severe vibrational and temperature cycling stresses. Severe conditions encountered in the use of a printed circuit board for large leadless chip carriers are also solved. These improved properties are achieved by providing special stress accommodating solder interconnections of conventional solder alloys and by miniature precision casting of these compliant, interposed interconnections as arrays. These cast arrays, due to the precision casting, may then be further modified and yet still maintain precise coplanarity during the entire chip carrier-to-PCB-joining process.

As still another aspect of this disclosure for securing leadless very high speed integrated circuits, the present device has, as one of the outstanding advantages, the ready ability to join, in a high speed production line, the compliant interconnect device to the TCE differing chip carriers. Assembly of the circuit devices may be accomplished in various orientations employing processes which do not affect the grain size structure of the metallurgical joints of the interconnection at the chip carrier and/or at the PCB interface. The above advantages are achieved using conventional tin-lead solder alloy technology. If special alloys are employed, improvements are likewise achieved above those observed because of the special alloy metallurgy.

In developing chip carriers which are generally of a rectangular configuration and conventionally most often encountered as a square plate on which an integrated circuit chip is mounted in a well thereon (e.g., in the middle), leads from the integrated chip are projected outwardly towards the edges of the chip carrier. These leads may be on the surface or sandwiched in the chip carrier. These leads may be either in a configuration resembling spider legs projecting downwardly to be inserted in appropriate apertures in a printed circuit board, or in a "leadless" configuration, i.e., as metallized pads on the chip carrier. Thereafter these pads are soldered by different methods to secure the pads to the printed circuit board circuitry. Various forms of "lead" containing chip carriers are used. These types of carriers are space inefficient and present severe assembly problems. The reject rate is relatively high. Additionally, parasitic circuit impedance is also experienced.

As the integrated circuit speeds are being increased, the parasitic effect of the leads such as the spider leg leads are a problem. As a result, a great emphasis has been placed on leadless chip carriers where the surface pads, usually around the periphery of the chip carrier, are joined directly to the circuit board. Various methods have been proposed for joining these leadless chip carriers to the circuit board.

Moreover, as the specifications for the solder joining or any other method of joining the chip carriers to the circuit board are very rigorous and must be precise, for each individual lead or pad, a great effort has been made to standardize these specifications.

A summary of these specifications is found in a publication entitled Guidelines for Surface Mounting and Interconnecting Chip Carriers, published by IPC, The Institute for Interconnecting and Packaging Electronic Circuits, Evanston, Illinois. This publication is designated by the publisher as "IPC-CM-78", and has been published November 1983. The definitions, terms and tests as used in this publication are employed for describing the presently disclosed device; for this reason, the above publication is incorporated by reference herein.

In accordance with the terminology used in the publication, the presently disclosed compliant interconnection array device is suitable for the leadless Type A, B, C and D chip carriers. However, the present device is equally useful for employment with other chip carrier modifications besides the above type chip carriers, and as an example, the present device is also applicable such as for the 20-mil center JEDEC Leadless packages. A 50-mil package is disclosed on page 4 of the above-mentioned publication, included the "leaded" Type A and Type B packages which may be surface mounted on a printed circuit board.

It is noted, such as in the above article, that the mounting difficulties increase with the number of input/output leads or pads on the periphery of the chip carrier.

With respect to the very high speed integrated circuits (VHSIC) such as described in Electronic Week, September 3, 1984, these are mounted on a chip carrier having a 180-pin array package. Needless to say, the precise mounting of the 180 leads, typically at 45 leads per edge, presents great physical difficulties which are drastically compounded when the electrical connection reliability is included.

0150928

-4-

It is also well known that reliability expressed as the average temperature cycling-electrical life expectancy of chip carriers decreases drastically as the lead numbers increase. Such data have been presented by Brierley et al in an article entitled Surface Mounted IC Packages -- Their Attachment and Reliability on PWB's, appearing in Circuit World, Vol. 10, No. 2, p. 28 et seq, 1984.

Moreover, the results of the temperature cycling indicate that the larger stand-off distances between the PCB and the chip carrier survive mechanically and hence electrically at least twice as long as those with small stand-off differences. Further, the results of temperature cycling also indicate that using different soldering components (considerably more expensive) result in a further improvement in reliability as compared to tin-lead compositions, especially for large lead or pad count chip carriers.

As an additional observation, improving the printed circuit board materials, from the TCE standpoint, using materials not conventionally employed in circuit boards results in a considerable improvement in the thermal life cycles. Still further, the suggestion has been made to use "leaded" chip carriers where high reliability is required. However, the present device in combination with the chip carrier or in combination with the chip carrier and PCB has the advantages of a "leaded" chip carrier, but without the inherent disadvantages of the leadless or pad type chip carriers. As it is evident from the above, a complex balancing of the various variables, at great expense, may alleviate some of the problems which have been encountered and described in the prior art concerning the surface mounted integrated circuit carriers.

As a result of the problems encountered in temperature cycling versus electrical life expectancy studies with chip carriers of a greater number of leads than twenty, reliability, expressed as failure occurrence (in electrical continuity) per given number of cycles, is a very important criterion in actual use. Failure has been defined as an open circuit or a high connection resistance ( 30 ) condition for more than one millisecond. Extensive studies of the factors which affect the leadless chip carrier solder joint fatigue life have been made. These studies have been published such as by Lake et al, entitled Some Factors Affecting Leadless Chip Carrier Solder Joint Fatigue Life, presented at the Twenty-Eighth National SAMPE Symposium, April 11-14, 1983. These studies suggest that the accelerated tests are approximations, and an appropriate "safety factor" must still be used. The magnitude of this factor has not been quantified but is dependent on all materials and processing conditions. The obvious incompatibility of a chip carrier which is conventionally made of alumina and the predominant glass/epoxy or polyamide multilayer boards have been described in the above article by Lake t al. This article further describes the solder joint configuration, solder joint metallurgy, and solder alloys. From the above studies it is evident that increasing the thickness of the joints and using "leaded" carriers showed excellent results. Moreover, the cycling tests also show that increasing the chip carrier distance from the circuit board increases the improvement in solder joint reliability, but that increase also introduces further parasitic loss in IC speed.

Besides attacking the solder joint interconnection failures, another prong in the thermal cycle-life span problem has been an attack on the mismatch between the TCE's for the printed circuit boards as well as the TCE's for the chip carrier traditionally made of alumina. Typically, the TCE mismatch between an alumina chip carrier and a glass/epoxy PCB has been of the order of magnitude of about 10 ppm/°K. For this reason, silicon carbide has been proposed as a ceramic for chip carriers. Silicon carbide has a very high power dissipation ability and an attractive TCE.

The strong point of silicon carbide has been alleged to be a better thermal conductivity than metallic aluminum, in fact it is more than nine times that of alumina, and 1.1 times that of beryllia. (Cf. Electronic Week, September 3, 1984, page 32.) Beryllia has also been used as a chip carrier, but its high cost has limited it to critical applications needing high heat dissipation.

Because of the above problems, there has also been a proposal to abandon the large lead chip carriers in the traditional square chip carrier configuration. Proposals have been made to have two parallel rows of J-leads lined up along the long sides of a rectangular chip carrier. Needless to say, a change of chip carrier configuration would dramatically and drastically alter the economics of circuit design. Circuit packaging and all the other problems associated with nonstandardized packaging or change to a new standard would adversely affect the existing technology.

The Applicants are aware of the following prior art which has attacked the above-described problems by suggesting various configurations for attachment of the chip carriers to the printed circuit board. The art consists of the following patents and references:

U.S. Patent 3,411,204 issued November 19, 1968 to G.R. Reid;

U.S. Patent 3,429,040 issued February 25, 1969 to L.F. Miller;

U.S. Patent 3,680,037 issued July 25, 1972 to Nellis et al;

U.S. Patent 3,680,198 issued August 1, 1972 to Wood;

U.S. Patent 3,719,981 issued March 13, 1973 to Steitz;

U.S. Patent 3,835,531 issued September 17, 1974 to Luttmer;

U.S. Patent 3,864,827 issued February 11, 1975 to Schreiner et al;

U.S. Patent 3,921,888 issued November 25, 1975 to Elliott et al;

U.S. Patent 4,008,300 issued February 15, 1977 to Ponn;

U.S. Patent 4,013,344 issued March 22, 1977 to Bescond;

0150928

-7-

U.S. Patent 4,027,936 issued June 7, 1977 to Nemoto et al;

U.S. Patent 4,179,802 issued December 25, 1979 to Joshi et al;

U.S. Patent 4,352,449 issued October 5, 1982 to Hall et al;

U.S. Patent 4,354,629 issued October 19, 1982 to Grassauer et al;

U.S. Patent 4,412,642 issued November 1, 1983 to Fisher, Jr.;

U.S. Patent 4,413,308 issued November 1, 1983 to Brown;

U.S. Patent 4,423,467 issued December 27, 1983 to Shaheen;

German Published Patent Application No. 1919567 published November 5, 1970;

Japanese Published Patent Application No. 50-62155 published May 28, 1975;

Japanese Published Patent Application No. 50-101857 published August 12, 1975;

Japanese Published Patent Application No. 51-665 published January 6, 1976;

Japanese Published Patent Application No. 51-10364 published January 27, 1976;

Japanese Published Patent Application No. 56-118388 published September 17, 1981;

Japanese Published Patent Application No. 57-132334 published August 16, 1982;

Japanese Published Patent Application No. 58-209194 published December 6, 1983;

Japanese Published Patent Application No. 59-9947 published January 19, 1984;

Lyman, Jerry, "Frame Permits Use of Glass Board", Electronics, June 28, 1984, pp. 54-5;

Cherian, Gabe, "Use of Discrete Solder Columns to Mount LCC's on Glass/Epoxy Printed Circuit Boards", Fourth Annual International Packaging Conference, Baltimore, Maryland, October 29-31, 1984.

Describing the prior art in a summation: it is evident that a great effort has been made to overcome the problems identified above or identified in the publications which have been cited for the prior art background. These problems by no means have been solved. As it is evident from the prior art, especially severe problems are present for the large pad, i.e., more than 48 pads on a chip carrier commonly mounted on printed circuit boards made of glass/epoxy composite.

In order to overcome the various complex solutions suggested by the prior art to minimize interconnection failure such as measured by the thermal fatigue or thermal-cycle life expectancy of the chip carrier mounted on a circuit board and especially the leadless chip carrier mounted on a circuit board, a new family of compliant, interconnecting devices has been discovered. This family of devices may be produced in various configurations and accommodates all types of circuit board materials from the most inexpensive to the most complex and expensive. Thus, the invention herein has minimized to a drastic degree the complexity of mounting large leadless chip carriers by providing a compliant, interposed interconnection device which, in combination with the chip carrier and circuit board, upon proper securement improves the reliability of the circuit connecting configurations in an outstanding manner.

These improvements come about because of the structure of the interconnection device, the structure of the individual connecting members between each of the individual pads, the accommodation of stresses, be these thermal, flexural, or vibrational stresses, and the elegant facility for joining the chip carrier to the printed board in a high speed operation.

In accordance with this invention, the compliant interconnection device consists of precision cast high temperature (relatively) tin-lead alloy solder connection means, which are thereafter joined simultaneously or sequentially with a lower melting temperature or eutectic tin-lead alloy to the chip carrier and circuit board. After soldering, such as vapor reflow soldering, the novel combination of the device, as soldered to the chip carrier, overcomes and/or minimizes the problems previously associated with the same solder alloy or soldering means or same soldering techniques. The novel interconnection device accommodates far better than the prior art devices the stresses which lead to failure. The novel interconnection device allows use of solder reflow techniques to improve further the configuration of each of the individual connections and thereby maintains a properly aligned true coplanar structure as well as vertically parallel structure between the circuit board the chip carrier and individual solder connections.

The interposed device further accommodates inherent individual differences vis-a-vis the space between the chip carrier, the printed circuit board and accommodates these differences around the periphery or in an interior array configuration such as for a leadless pad grid area array.

Still further, the method for mounting the chip carrier to the printed board is additionally improved by the non-elastic method with which each of the small precision cast microleads or columns of the solder are interposed between the printed circuit board and the chip carrier allowing for very precise center-to-center spacings. Such spacing may be controlled with great assurance for a center-to-center distance, e.g., from .100 to 0.020 inches (2.540 to 0.508 mm). Excellent control in the quality of each of the solder columns are thereby being maintained which columns are thereafter unaffected by solder migration, flux migration, and flux cleaning when joining the chip carrier to the printed circuit board. The last has been an especially troublesome condition for the leadless chip carriers in the prior art devices and has been one of the quality control problems plaguing the industry.

Still further, in accordance with the present invention, it has also been found that the compliant interconnection devices may be manufactured rapidly, allowing excellent quality control for each of the solder columns in a peripheral and/or interior array. In a series circuit element assembly, the present device lends itself to rapid assembly line production, as well as step-and-index individual production, or even individual assembly of the chip carrier with the printed circuit board.

As another aspect of this invention, it has been found that the interconnection device may be secured with equal reliability in various positions, e.g., up or down positions. Further, by using a solder column array carrying plate, additional benefits are gained by the cooperation of the plate with the solder columns such as incorporation in the plate of production, placement, cooling, or heat dissipative means. This plate need not be removed in the spaced between the chip carrier and the printed circuit board, yet solder fluxes may be readily removed therefrom by reason of the plate thinness and length of the cast solder columns. This plate provides for still other benefits such that it may also carry circuit elements, e.g., for joining various solder columns. One can use heat dissipative material, e.g., impregnated plastic such as NOMEX or aramid paper, and/or paper, and also provide baffling and/or holes which further improve the heat dissipation.

In accordance with the present invention, a compliant interconnection device of the type having a plurality of spaced, individual interconnections extending through a plate is characterised in that the interconnections are lockingly engaged with the plate.

Other and various benefits will be made evident from the description of this invention in greater detail below and by reference to the drawings wherein:

FIGURE 1 shows, in a schematic perspective, the production sequence of an embodiment of the compliant interconnection device;

FIGURE 2 shows, in a schematic perspective, an assembly sequence for a chip carrier with the compliant interconnection device;

FIGURE 2a shows, in an isometric view, the steps of combining a compliant interconnection device with a chip carrier and a printed circuit board, whereby the device is being used to join a chip carrier with the printed circuit board;

FIGURE 2b shows, in a schematic perspective, a completed assembly with the compliant interconnection device;

FIGURE 3 shows an isometric view of the assembly in Figure 2a, but in greater detail than in Figure 2a;

FIGURE 3a shows, in cross section of the assembly in Figure 3 along lines 3a-3a thereof, an embodiment of an individual solder column;

FIGURE 4 shows a top view of the compliant interconnection device;

FIGURE 5 shows a view of another embodiment of the compliant interconnection device;

FIGURE 5a shows an isometric view of an individual in-line solder column interconnection along lines 5a-5a of Figure 5;

FIGURE 5b shows still another embodiment of an individual staggered soldered column suitable for interconnection in the device of Figure 5;

FIGURES 6 to 6c show, in a cross-sectional view, a solder column casting device illustrating the various stages in the formation of an embodiment for the solder column shown in Figure 3a suitable for the compliant interconnection device;

FIGURE 7 represents, in a partial section before solder joining, one embodiment of an individual solder column in an array of solder columns with a partial section of a chip carrier and a printed circuit board;

FIGURE 8 represents, in partial section, the assembly shown in Figure 7 but now in a soldered condition;

FIGURE 9 illustrates, in a partial cross section, a compliant connection device further modified with a pre-applied low temperature solder cap;

FIGURE 10 illustrates, in an isometric view, another embodiment where additional circuit elements are being used with the compliant interconnection device;

FIGURE 11 illustrates a cross section of the assembled device shown in Figure 10 before solder attachment;

FIGURE 12 illustrates, in cross section, the assembly shown in Figure 11, but after solder securement of the assembly;

FIGURE 13 illustrates a phase diagram of a tin-lead alloy system which, in combination with the interconnection device, allows the tailoring of the devices for various reflow soldering temperature applications and for various reflow alloy characteristics;

FIGURE 14 illustrates a graph of thermal cycle life characteristics for a chip carrier with a given number of leads as a function of various stand-off heights for a typical alumina leadless chip carrier surface soldered onto an epoxy/glass printed circuit board substrate.

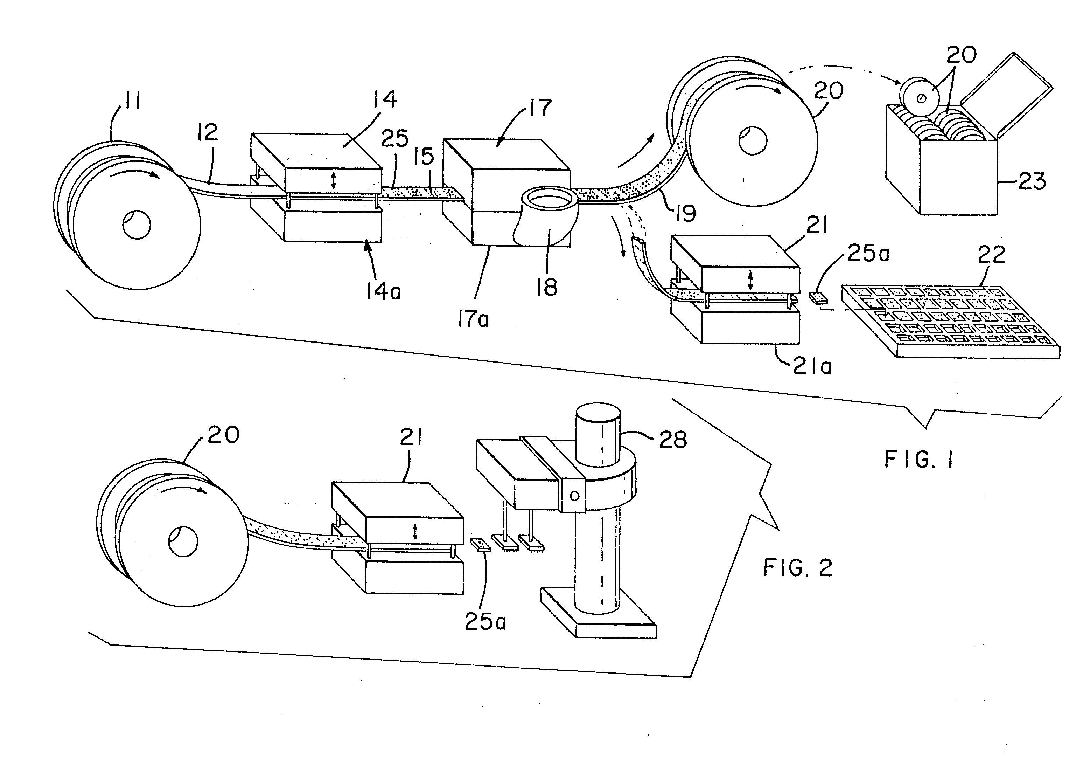

Turning now to Figure 1, shown is a reel 11 from which a suitable strip of paper 12 has been fed into a pattern punch die 14 for the paper 12. Conventionally, the paper 12 is a product called NOMEX which is an aramid paper made of fibrillated polyaramid fibers and suitably impregnated, if desired, with additional materials. Instead of the NOMEX paper, another suitable starting material is a clay-coated paper. Each of the individually punched patterns on the tape are later cut to form a plate 25.

One of the requirements for a suitable plate 25 material made from the paper 12 is that it is unaffected by humidity, has excellent dielectric strength which is fairly invariable over the operating conditions, and the plate is not affected by flux or solder material and is inert thereto. However, if the plate 25 is sought to be dissolved (a less preferred alternative), the paper or any other material must be capable of dissolution and removal. Other requirements are dimensional stability, inelasticity, flexibility, and a preferred temperature coefficient of expansion which is reasonably between alumina and glass/epoxy PCB. The objective is not to add to stresses originating from the plate 25 to the stresses imposed on the interconnections between the leadless chip carrier and the printed circuit board.

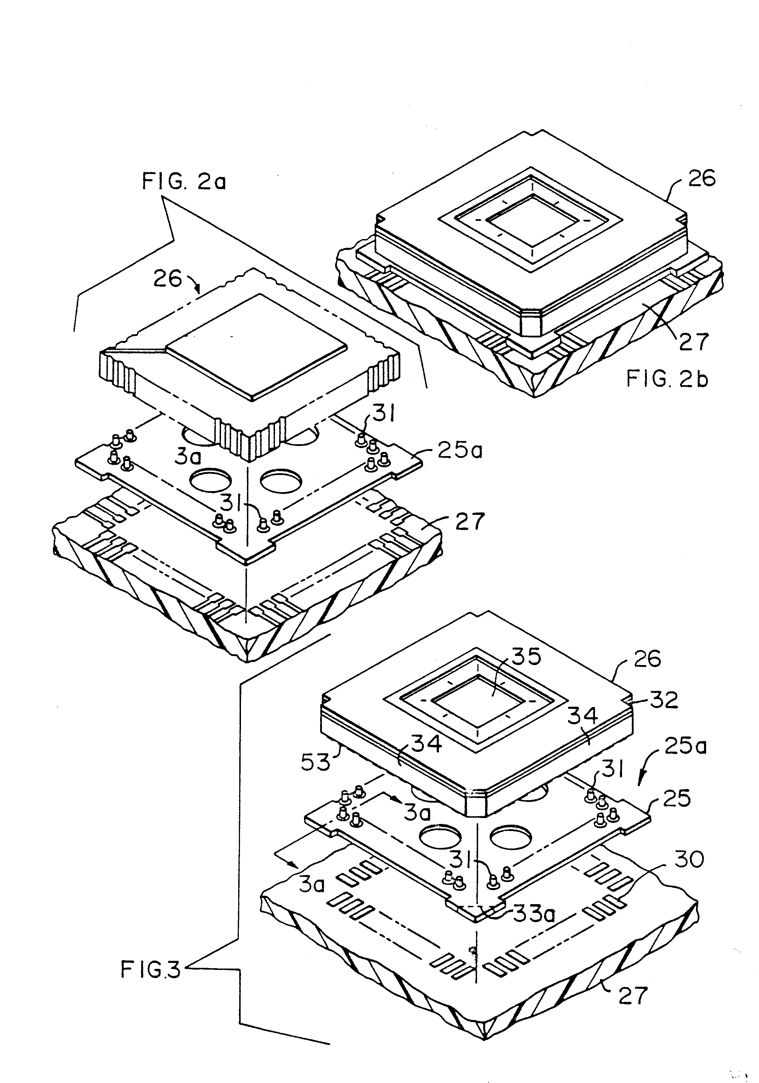

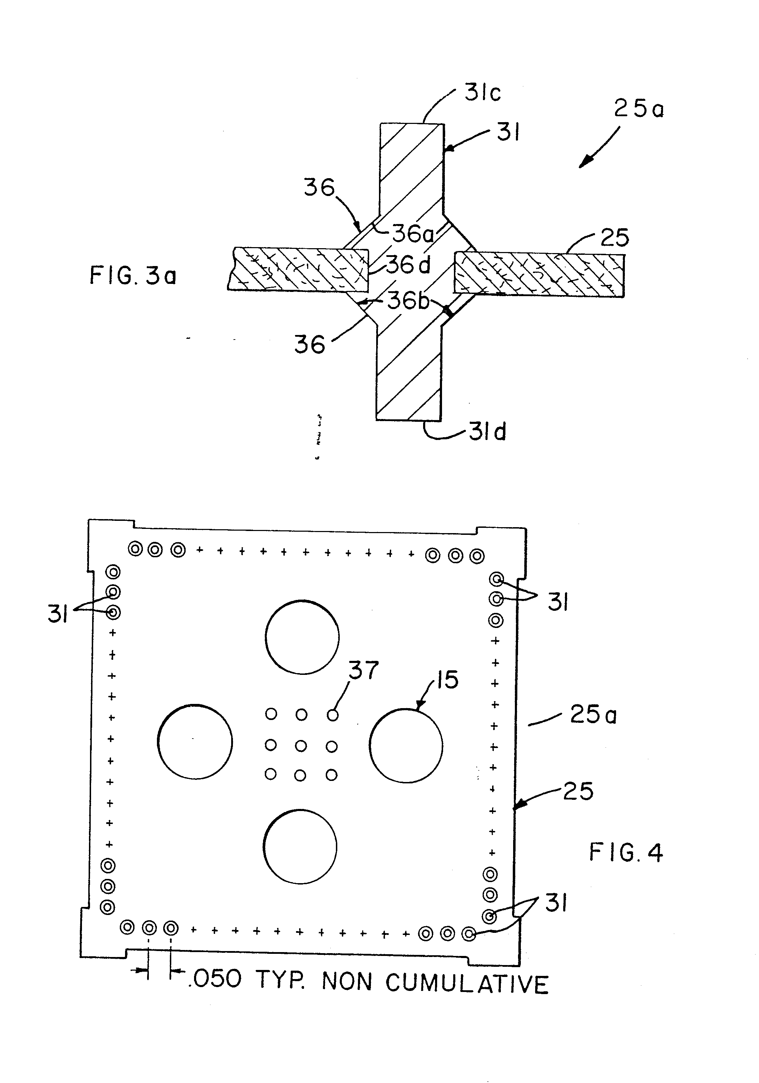

Typically, the plate thickness may range from 0.025 to 0.003 inches (0.6350 to 0.0762 mm), and even less. Plate rigidity may avoid some of the jigs and fixtures in an assembly operation, but flexibility must be sufficient to obtain coplanarity and vertical positioning of each of the interconnections, i.e., columns 31, shown in Figure 3, when placed onto a PCB after reeling and handling. Of the above-mentioned materials, the NOMEX paper is preferred for the plate 25 material.

Additional materials which may be used are beryllia or silicon carbide impregnated plastic materials, or like heat dissipative materials which are still insert to the flux cleaning materials and have excellent dimensional stability and rigidity. These, however, wear the dies used to punch holes in the plates. These impregnants or fillers for the paper material aid in heat dissipation, as well as reduction of transient temperature gradients and provide for a more equal heat distribution. An ability to operate at ideal ambient conditions, of course, creates a longer life to a solder joint and thus the suggested paper 12 material which must suitably answers the thermal load imposed on the particular circuit should be selected based on the above prescription.

In the paper punching die section where the dies have been represented as 14 and 14a, around the periphery thereof and in the center suitable apertures are punched by a plurality of individual dies corresponding to the number of individual solder joints or interconnections or apertures as further explained herein. Any other holes may also be punched in the plate 25 during this operation. The holes such as 15 shown in Figure 3 are for lightening the plate 25 as well as for providing access to the interior thereof for flux removal and easier heat dissipation.

After the paper strip 12 with the multiple plates 25 has been prepunched, it is then moved into the solder column casting section identified as 17 and 17a. The solder is typically kept in a heated section 17a at a temperature sufficient so that precision casting is achieved in the casting section. A suitable reservoir 18 is kept under an appropriate hydraulic pressure. This achieves casting each of the plates 25 in a step-and-index manner, i.e., intermittently.

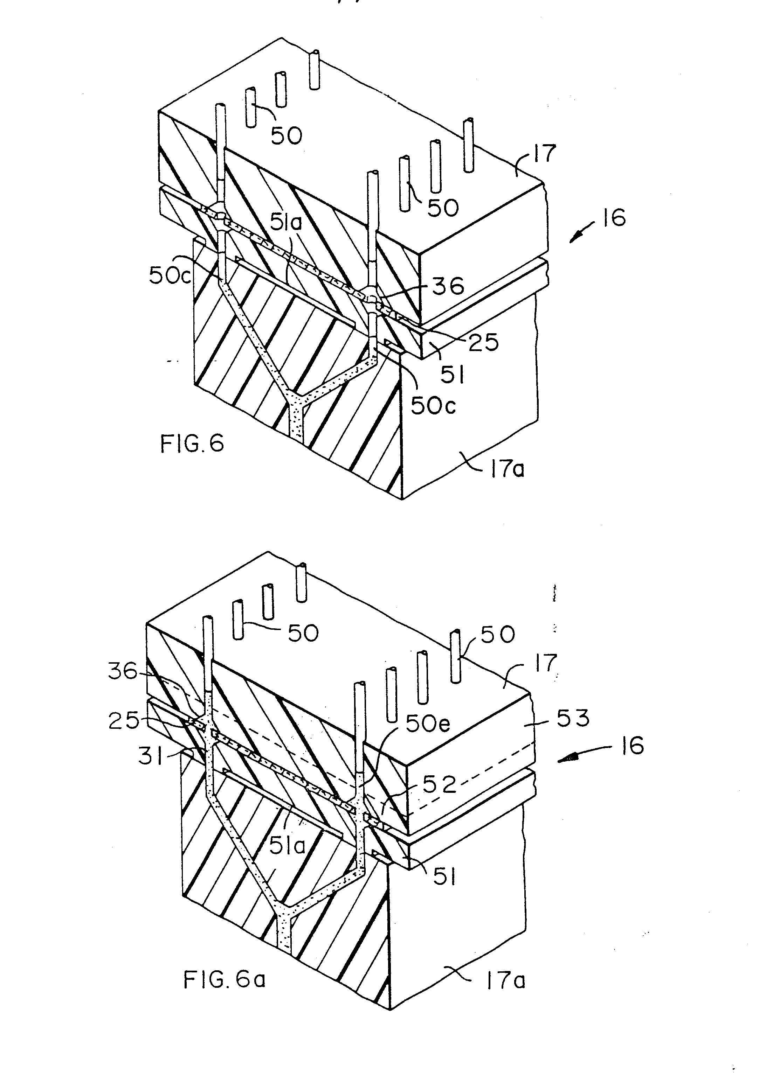

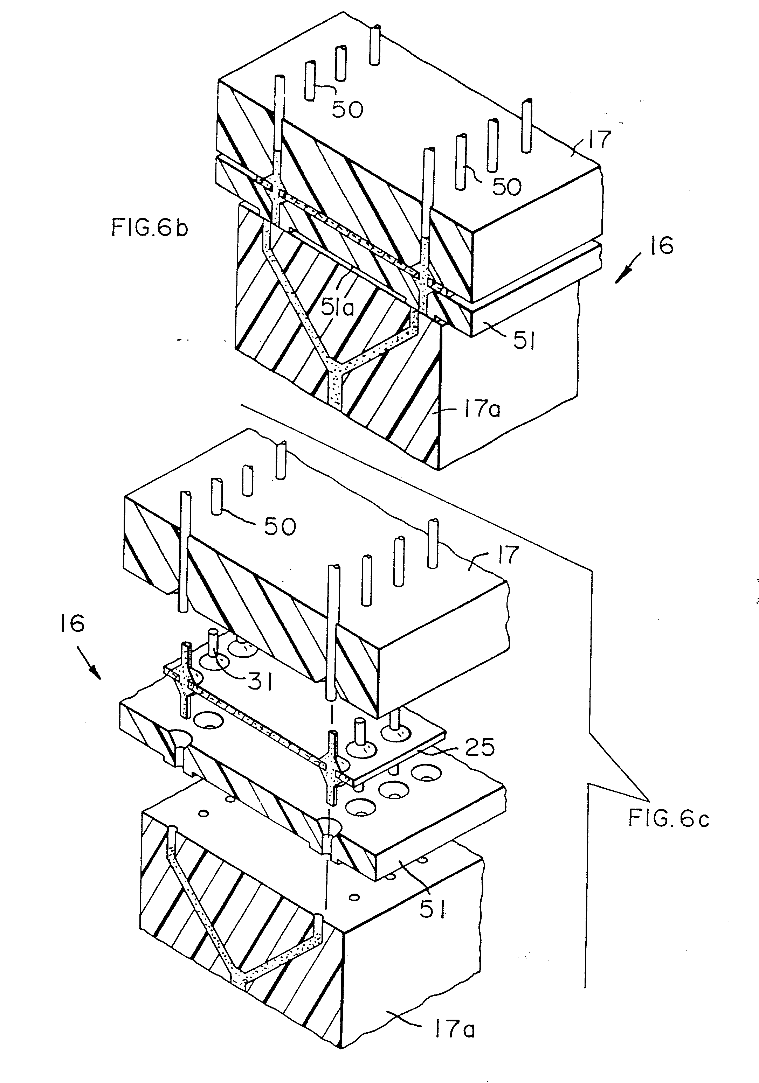

As it will be further explained such as with references to Figures 6 to 6c, the actual casting operation is a complex interaction of steps. During the casting process, the punched holes serve the purpose of defining the passages for an appropriate liquid solder flow. Each of the flow passages defines a column configuration.

After the casting operation, the obtained individual plate 25 sections with the solder columns 31 in plate 25 are shown in Figure 3. These plate sections have been called "compliant interconnection devices" 25a. These plates, while still in a finished tape form 19, are reeled onto a reel 20 for shipment to a user in a container such as 23. Typically, a user will take one of the reels 20, as shown in Figure 2, and will then individually cut each of the devices 25a in a cutting die 21.

These devices 25a are then appropriately manipulated for placement on a circuit board 27 and/or a chip carrier 26 as shown in Figure 2a. As one of the advantages herein and as it will be further explained, the device 25a may be mounted in an up or down position, and on either the chip carrier 26 or the printed circuit board 27 or simultaneously on both.

A schematic illustration of the manipulative steps has been shown by a robot arm device 28 which should aid in understanding how device 25a is used. The product is typically assembled in a manner such as shown in Figure 2a where the leadless chip carrier 26 is placed on the device 25a which, in turn, is placed on the printed circuit board 27. For a selected assembly and referring to Figure 3, however, various methods may be employed. These consist of either placing the solder flux or paste on the chip carrier 26 pads 53 and the printed circuit pads 30 or on the device 25a solder columns 31. In any event, further embodiments will be described herein which assure high quality control and thus longer fatigue life for the solder attachment of the chip carrier.

An assembled device is illustrated in Figure 2b with the circuit components now in place and the compliant interconnection device 25a barely visible in the assembly.

Describing in further detail the present invention, an isometric view of the assembly in Figure 3 shows chip well 35 on the chip carrier. The chip carrier 26 may have corner placement notches 32 or a cutoff corner(s) indicated by reference numeral 33. Edges 34 may be in registry with appropriate assembly jigs for the device 25a, as well as the PCB 27 so that a precise registry of the metallization on the PCB 27 and the chip carrier 26 may be achieved. Chip carrier pads 53 and printed circuit board pads 30 must align through the solder columns 31. This alignment and position must be maintained during the assembly and soldering operation. If slight misalignment occurs, the wetting characteristics of the columns 31, along with pads 30 and 53, will caused the melted solder with its inherent surface tensions to effectively attach the columns to the pads with good solder fillet characteristics.

Appropriate corner registry may be achieved such as by also providing a cut corner shown in a dashed line for the device in Figure 3 as 33a.

Each of the solder columns 31 shown in Figure 3 represents one embodiment of a particular solder column type. In Figure 3a, column 31 is shown in greater detail. As illustrated, the plate 25 has been positioned in a specific relationship with respect to the solder column 31. Locking collar 36 identified by the upper fillets 36a and lower fillets 36b are an important element in the device 25a. These locking collars 36 assure and provide for a number of advantages over the prior art devices known to the Applicants. Thus, the locking collar 36 and the plate 25 cooperate to assure appropriate coplanarity between the upper and lower column surfaces 31c and 31d, respectively. These surfaces 31c and 31d must be substantially parallel, must maintain this parallelism or coplanarity for the entire assembly during the production assembly and must not undergo change during the soldering stage of the process. The coplanarity must furthermore be substantially identical for each of the surfaces, namely surfaces 31c and 31d, and for each of the solder columns 31. The columns 31 must have substantially the same metallurgical behavior before soldering and after soldering.

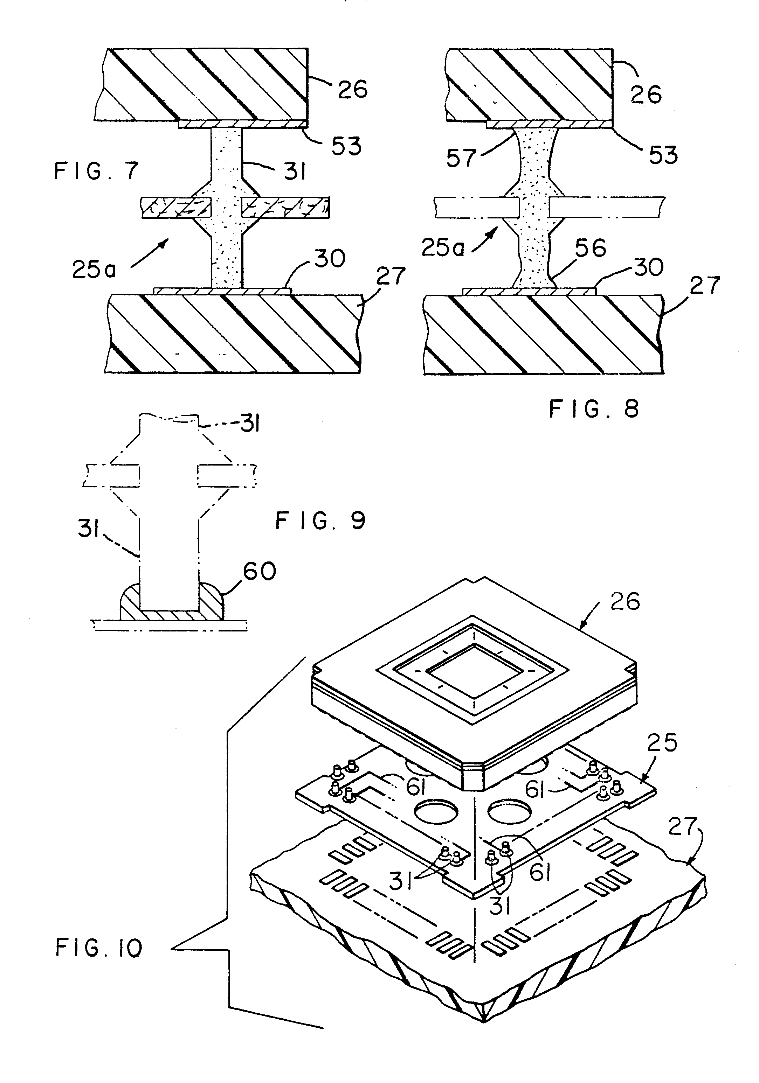

The coplanarity, however, must be such that it is not rigidly maintained by the plate 25, but the plate may accommodate imposed stresses with compliancy also contributed by the relative movement of a solder column 31 in the neck area 36d, as well as at the additional lengths thereof. As a further benefit, the solder filleting 57 and 56 (shown in Figure 8) at the top and bottom, respectively, provides additional column rigidity.

This rigidity is important in the assembly process as well as the ruggedness with which these precision cast, miniature columns 31 have been found to operate under the severe vibrational and temperature cycling operating conditions. Although larger columns may be used for fewer leads, these columns are typically of a diameter of 0.020 inches (0.5080 mm) and less for a 44-pad chip carrier. The column diameter, of course, depends on the column-to-column spacing. These diameters again will be based on the large leadless chip carrier configuration reaching, as mentioned before, up to 180 pads around the periphery of the device. It is noted that column 31 center-to-center spacing of .100 to .020 inches (2.54 to 0.5080 mm) are within the contemplation for device 25a. For a 44-pad chip carrier, a 0.050 inch (1.270 mm) center-to-center spacing is illustrative.

As shown in Figure 3a, the column may only be from about 0.12 inches (3.048 mm) to considerably shorter column height, such as down to 0.050 inches (1.270 mm). Shorter columns 31 are possible due to the improved compliancy characteristics of these, but for the reasons further discussed herein, it has been found that an appropriate column height such as 0.080 inches (2.032 mm) functions outstandingly well. Thus, the column height as shown in Figure 3a may be symmetrical along the long axis or along the centerline of plate 25, but other configurations are possible and have also been provided herein.

As part of the plate 25 configuration shown in Figure 4, the columns 31 which are traditionally around the periphery thereof may further be supplemented by interior grid-like array of additional columns serving same or different purposes. For example, the columns 37, which may be of larger and smaller diameter as the column 31 shown in Figure 3a, may be for the purpose of heat dissipation. These columns have been shown in a grid pattern of nine, but the entire area may be of fewer, but larger, columns. The interior columns 37 may also facilitate assembly of the device. The lightening holes 15 which have also been shown in the top view in Figure 4 provide access during the flux removal operation and serve other purposes such as heat dissipation by convection cooling. Additional heat dissipation, as it is well known, is achieved by providing heat sink devices connected to interior columns 37, and these induce the heat transfer more readily in the space between the chip carrier 26 and the plate 25 and the printed circuit board 27 and the plate 25 again.

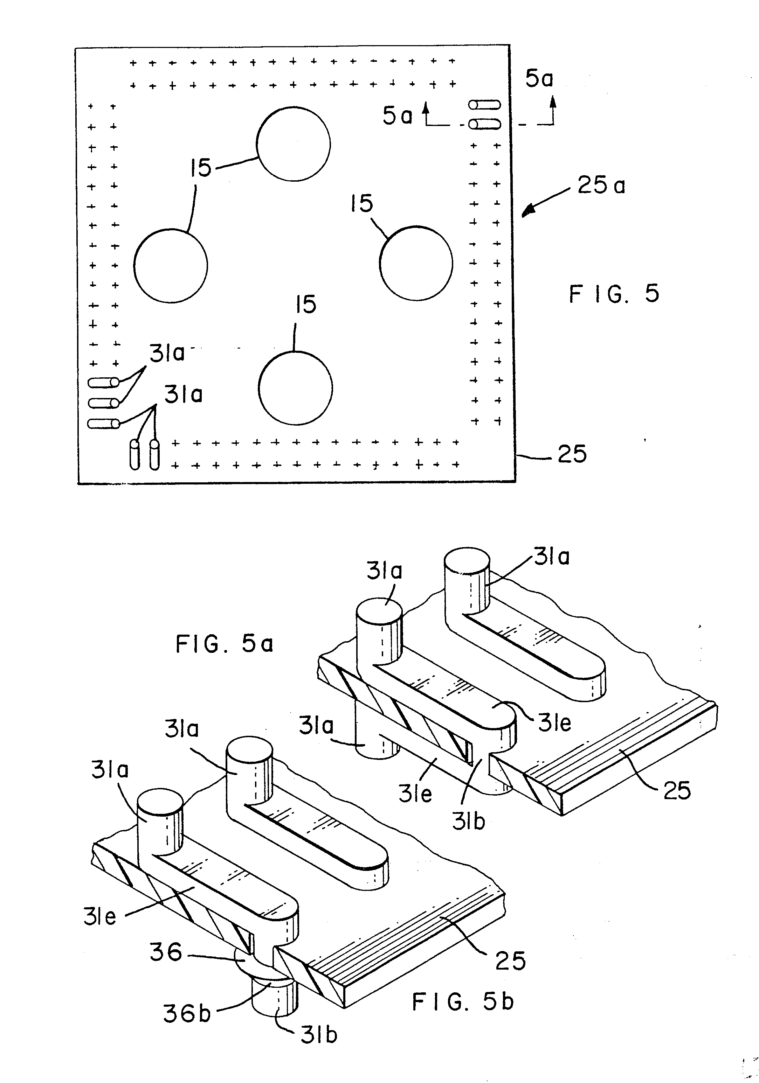

Another embodiment of the plate configuration with different solder columns is shown in Figure 5. Each of the columns in Figure 5 have been identified as 31a, and these, however, have further configurational variations. A view along line 5a in Figure 5 depicts this embodiment in Figure 5a. Although the column height and the column coplanarity has been maintained in an identical fashion, the plate 25 supports each of the columns in a different fashion to provide greater movement in all three principal directions (x, y, z), i.e., with a second column 31b and members 31e. The added flexibility and compliancy is thus assured for the especially troublesome temperature cycling conditions which may be encountered with devices such as, for example, found in the automotive field where the impedance considerations are not as critical.

For applications where impedance considerations are more severe, the embodiment shown in Figure 5b is considered to be more suitable. Instead of the cast solder column 31a being an entire locking collar as shown in Figure 5a, a locking collar 36 is provided for the device shown in Figure 5b. This locking collar resembles the locking collar shown in Figure 3a. It is, again, provided with fillets 36b and thus secures appropriately in the plate 25 the staggered column embodiment shown in Figure 5b.

In any of the foregoing solder columns, whether the direct column in Figure 3a, in-line column in Figure 5a, or the staggered column in Figure 5b (or intermediates thereof), an important consideration is the rigid locking ability by means of the locking collars cooperating with the plate 25. Consequently, the plate 25, in accordance with the present invention, has a two-fold function. One, it secures in a coplanar relationship the vertical interconnection columns 31. Another function is for the plate 25 to act as a casting surface so that the microcasting technique uses the plate 25 as part of the mold die. If the plate were of a soft, elastic material, e.g., foam, or would be easily distortable, the coplanarity may not be as easily maintained after the casting operation has been completed. A "spring-back" inherent in such a soft plate would then manifest in a distorted coplanarity as well as the distorted verticality of each of the interconnecting columns 31. Hence, the cumulative effect of a soft plate material would be unwanted unless the plate material has no effect except to maintain some, but not critical, verticality. Under those conditions, even then a soft plate material has an undesirable manufacturing side to it, because a soft plate has a tendency not to maintain a true column relationship; that problem then requires further solutions such as each column must be jigged in soldering, etc. Any of the surface irregularities imparted by solder paste, flux paste, chip carrier 26 or PCB pads 53 and 30, respectively, are easily accommodated by the novel device in the soldering operation, whereas these accommodations are considerably more troublesome with the prior art devices.

As mentioned before, the total dimensions for these columns are typically dictated by the spacing of the array around the periphery thereof. Embodiments such as shown in Figure 5a and Figure 5b are more suitable for the peripheral placement of any number of pads. Embodiments such as 3a are, however, more suited for greater number of pads and closer arrays. It is also possible for the entire plate 25 to be arranged in an appropriate grid configuration such as illustrated by the small grid shown as solder posts 37 in Figure 4.

Nevertheless, it is emphasized that the various solder column castings which can be achieved and are shown by the three embodiments shown in Figures 3a, 5a and 5b are only for purposes of illustration. The solder interconnection casting is made possible by the plate and die rigidity in a combination which maintains true coplanarity, not only between the upper and lower surfaces of columns 31 in the compliant interconnection device 25a, but also a true verticality for each of the individual microinterconnections around the periphery of the device. For the very high speed integrated circuits such as discussed previously where different packaging suggestions have been made, such that only the long edges of the rectangle would carry the interconnections to a circuit board, the present device lends itself admirably to interconnect chip carriers with the printed circuit boards.

These surface mounted large leadless chip carriers 26 may then be tailored appropriately and only two rows of the solder columns are then case in place along the plate 25 with the dimensions corresponding to the newly suggested chip carriers 26 and of a type such as shown in Figure 5b.

The reason for the outstanding plate behavior becomes more evident when the microcasting operation is examined in more detail in Figures 6a to 6c where the step-wise casting operation has been shown.

As illustrated in Figure 6, the casting die 16 consists such as of a top plate 17 and a bottom plate 51 resting on a heated nozzle 17a which maintains the metal in a liquidus condition. The molten metal nozzle 17a has a heater (not shown). It maintains the metal at a temperature such that the metal can be extruded through and simultaneously via each of the individual solder cast column conduits or passages 50c corresponding to the number of solder columns 31 of dimensions which have been prepunched in an appropriate size and shape in the plate 25. Hence, for each of the number of leads, the cross section of the molten metal nozzle conduit 50c illustrated in Figure 6 is identical or different. The dies 17, 51 and 17a resemble, in a top view, a plate 25 such as shown in Figure 4 or Figure 5 with the columns being, respectively, such as shown in Figures 3a, 5a or 5b.

On the die top plate 17, which is also called sometimes the ejector half of the die, each of the solder columns' height is maintained for the desired length thereof by ejector pins 50. The metal flow distance is generally identical from the nozzle to all of the pins. However, if a column 31 is intended to protrude through a PCB, then individual length adjustment for each of the columns is also possible. The molten metal is being maintained in the molten metal reservoir at a high temperature such as 750° Fahrenheit, but the nozzle for the heater is maintained at a lower temperature or at or slightly above the metal melt temperature. This temperature condition has a two-fold function. One, the molten metal always works against a pressure gradient, and two, the solidification takes place rapidly. Suitable injection pressure is achieved such as by a hydraulic ram, not shown, which exerts its pressure on the molten metal reservoir 18 shown in Figure 1. As illustrate in Figure 6a, the metal as it is being forced through the nozzle conduits 50c, while it is in a fairly hot state, is typically in a barely liquidus region when referring to a phase diagram.

In Figure 6a, the ejector pins have terminated the metal movement with the locking collars 36 having been formed. The ejector half of the die 17 maintains a pin array by appropriate means so that all of the coplanarity is being maintained between the bottom plate and the top of the pin column. The plate 25, due to its inelastic nature, assures substantially no sideway flow and thus ensures the electrical integrity to each of the individually cast solder columns 31.

The bottom plate of the die 51 is typically at a lower temperature than the nozzle 17a, and thus assures, due to its relatively larger size and the air space 51a, an insulation sufficient to achieve at the same time fairly rapid chilling of the columns 31.

It has also been found that in applications where a further assured coplanarity is desired, the ejector plate 17 is split in half to form first die section 52 and second die section 53. The ejector pins 50 then function in a different manner. These pins 50 in the first part of the operation are raised so that the metal can form a heated riser of sufficient height allowing also for some venting capability should such be needed.

Thereafter, the first die section 52, shown in Figure 6a by phantom lines, is held relatively rigid vis-a-vis the second die section 53. The height of the columns 31 is established by the second die section 53 first being moved relatively to the first die section 52, shearing off the risers 50e. Thereafter, a second die section (not shown) is placed in a corresponding position to the plate 17 with ejector pins 50, being now in position to eject each of the columns 31, after the bottom plate 51 shears off the bottom of the pins 31 as shown in Figure 6b. Typically, the ejector pins 50 eject the columns 31 as it is shown in Figure 6c.

Figures 6 to 6c illustrate the steps in which coplanarity may be achieved by the two different methods. As shown schematically in Figures 6 to 6c, the relative shearing motion on these microcolumns at the hot metal temperature is relatively easily accomplished with true coplanarity still being maintained.

As it is evident, the temperature of these die plates 17, 51 and 52 and nozzle conduits 50c are appropriately maintained so as to assure the proper operation of the casting procedure. For each of the selected solder alloys, these temperatures are established relative to each other.

Thus, if these precautions are observed, a very finely detailed column 31 is obtained for each of the interconnections in the device 25a.

In Figures 7 and 8, the assembly-solder sequence is further amplified and illustrated. When the plate 25 carrying each of the columns 31 is placed on or interposed between the printed circuit board 27 and the chip carrier 26 with the printed circuit board carrying its metallized pads identified as 30 in Figure 7 and for the chip carrier as 53, the coplanarity is thereby assured by the column integrity for each of the individually precisely microcast columns 31.

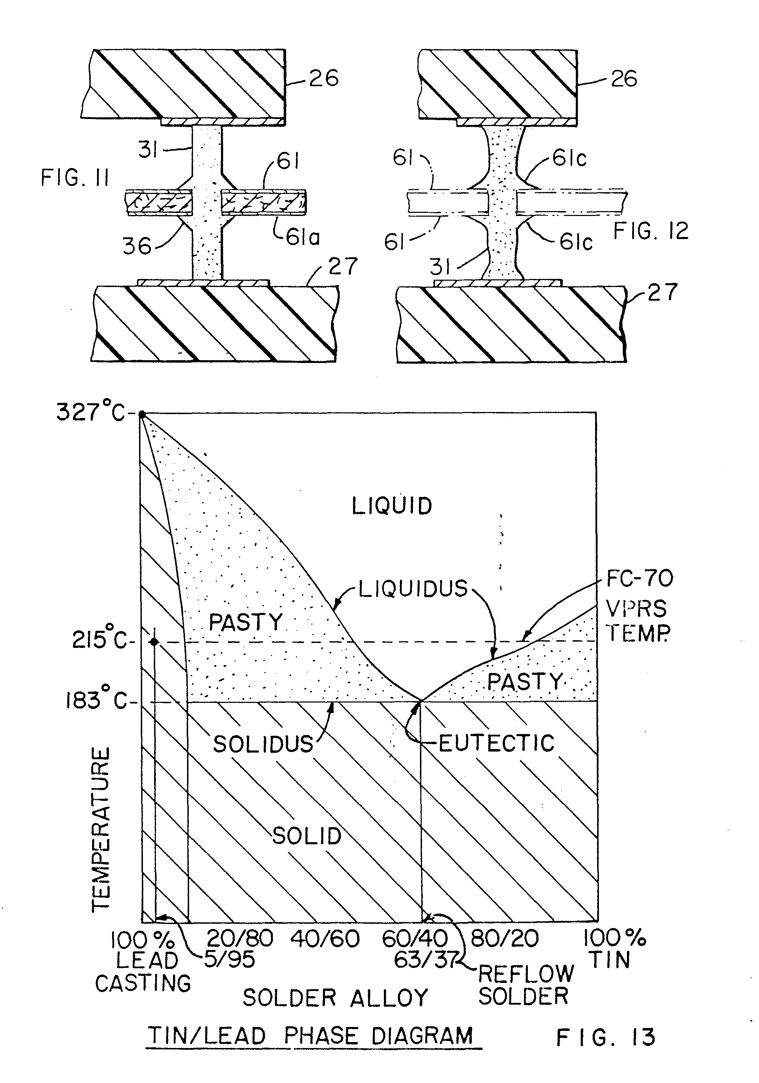

With reference to Figure 8, the device 25a as affixed to the chip carrier 26 and printed circuit board 27 and as used in service is illustrated by that Figure. Taking Figure 8 in conjunction with Figure 13 shows the actual soldering process. Typically, the interconnection column 31 is cast from a lead-tin alloy composition having 95 percent lead and 5 percent tin. By reference to the phase diagram in Figure 13, the melting point of that composition is in the vicinity of 327 degrees Celsius. At that temperature, tin-lead solder alloy is solid. At 327 degrees Celsius, 100 percent lead composition is liquid. A slight change in temperature and/or alloy composition will place the solder alloy in a liquidus or solidus condition. The liquidus condition is also called a "pasty" condition, i.e., where solid and liquid phases coexist. These have been indicated on the tin-lead phase diagram as the "pasty" region.

At a eutectic point of 63 percent tin, 37 percent lead, the liquid temperature of the alloy is about 183 degrees Celsius. Consequently, a spread of 144 degrees Celsius in the respective melting points of the alloy from which the column 31 is formed and at which a eutectic mixture of a solder used is available for the soldering operation.

In a vapor reflow method of soldering, the component parts to be soldered are brought to a selected temperature at which the vapor from a boiling liquid transfers heat, via the vapors, to the components which must be soldered. A reflow solder system designated as FC-70 VPRS and available from 3M is typically operated at about 215 degrees Celsius which is 31 degrees higher than the eutectic melting point of the 63/37 tin-lead alloy.

Inasmuch as the eutectic solder alloy will melt at 183 degrees Celsius, and the solder column 31 still maintains its rigidity and integrity, the solder reflow method lends itself to the melting of a solder alloy which is deposited on the solder column 31 in whatever form it is found to be most advantageous. Typically, the solder alloy may be deposited as a paste either admixed with the flux or the flux may be separately deposited such as on the chip carrier leads 53 or the printed circuit metallized part 30. In either event, the solder column 31, because it is maintained in the rigidly upright position by plate 25, forms upon pressing together with the chip carrier 26 and the printed circuit board 27 a fairly cohesive structure. If further cohesion is needed, adhesive elements are sometimes incorporated in the paste. Additionally, adhesive deposition such as on the center column 37 shown in Figure 4 also assures placement of the chip carrier on the printed circuit board.

The precise placement is further assured by appropriate jigs which may fit such as in the indented corners 32 shown in

0150928

-24-

Figure 3, or the coregistered corners of the chip carrier 26 and plate 25 shown in Figure 3 as 33 and 33a respectively.

Various other methods may be employed for securing a placement, but in any event the assembly procedures are facilitated because of the fairly high strength coplanar structure of the device 25a which can bear considerable loads imposed on it during the assembly process to assure proper spreading of the paste and securement of the unsoldered assembly.

As a further benefit, during this operation the plate 25 also maintains the columns in a rigid position as a result of the collar lock 36. Upon the assembly of the chip carrier 26 with the printed circuit board 27 with the device 25a interposed therebetween, this assembly may then easily be baked so as to secure it further and maintain the rigidity of the structure. This baking drives off any volatiles from the solder paste and causes it to change to a cement-like material.

Thereafter, the entire structure is placed in the vapor solder reflow chamber where the assembly is brought up to the thermal conditions necessary for reflowing the solder paste and forming the properly adhering structure between the leadless chip carrier 26 and the printed circuit board 27 via the compliant interconnection device 25a.

As most of the interface failure between the column 31 and the metal pads or leads in the chip carrier, shown as 53 in Figure 8, occur at the interface of these, the formation of a proper fillet 57 is especially beneficial for the presently disclosed device.

The same phenomenon, of course, occurs at the bottom of the assembly such as on the metallized pads 30 for the circuit board 27. However, inasmuch as the assembly may be carried out in and up or down position and step-wise, the proper fillet 57 formation is experienced under any of the conditions. Thus, the solder upon reflowing will contribute considerably to the performance of the properly designed device 25a. At the same time, controlling the amount of solder allows the proper spreading of the fillet 57. Still further, partial assembly allowing a top fillet formation 57 and bottom fillet formation 56 allows various fillet shapes to be obtained based on the center-to-center separation width of the metallized pads, such as 30, on the printed circuit board.

It is nevertheless noted that a one-step operation is far more advantageous than a multi-step operation. For proper fillet formation, a device has been provided such as shown in Figure 9. The solder cap 60 shown in Figure 9 aids in establishing different fillet configurations or different material flow properties based on the surface tension and remelt temperature considerations of a particular alloy or paste or alloy combinations. These are dependent upon the alloy content and the alloy additives. However, in Figure 9, because of the rigid structure, it has been found convenient that solder caps 60 may be placed on one or both ends of the solder column 31 and, if step-wise assembly at different temperatures is sought, such step-wise assembly may be achieved first by soldering to the printed circuit board a solder cap 60 reflowing at a higher temperature and thereafter placing the chip carrier on top thereof and reflowing solder at a lower solder alloy temperature.

Due to the rigidity and the precise casting of the column 31, solder caps 60 of various compositions may easily be placed on the individual columns from a die machine or even by reflowing in a die set-up (not shown).

Because the strong columnar behavior of the column 31, such as for the embodiments shown in Figures 3a or 51 or 5b whereby the plate 25 immeasurably aids in maintaining the column spacing, combinations heretofore impossible to be achieved in soldering techniques have now been shown. These interconnections, in general, are now utilized to improve still further the proper solder behavior for the compliant interconnection device 25a. Each of the tips of each of the individual compliant interconnection device columns 31 may also be coated by controlled immersion.

Other methods such as registered gravure coating by immersing each of the tips in a aperture in a drum (not shown) with appropriately spaced holes corresponding to each of the columns 31 may also be used. The gravure deposition method provides for control, not only based on the size of the hole, depth thereof and viscosity of the paste, but also the paste might be transferred under hot conditions.

The PCB 27 and the chip carrier 26 metallization pads 30 and 53, respectively, may also, by silk-screen printing, be treated only with flux. Flux removal is also one of the important aspects of the present invention. Because of the choice for the spacing and length for each of the individual columns 31, as well as the plate configuration, each of the devices 25a may be appropriately designed. Flux removal, after soldering, thereby does not present a problem. Flux control is especially troublesome as flux migration is affected by humidity. Shorting of the circuits is an ever-present problem due to flux contamination. In accordance with the present invention, the device 25a lends itself admirably to the flux removal because its interconnect space, such as .070 inches (1.778 mm), is sufficient to allow facile conventional washing and solvent intrusion and exit with the contaminants.

The well-known problems such as illustrated by Capillo in an article entitled "Surface Mounting Assemblies Create New Cleaning Challenges", Electronic Packaging and Production, pages 78 et seq., August 1984, are illustrative of the problems which the present device overcomes.

Turning now to the embodiment as disclosed in Figures 10, 11 and 12, these illustrate the further benefits which are achieved when employing a plate such as disclosed herein. That embodiment shows another aspect possible when plate 25 is employed. Thus, additional metallization is now possible on plate 25. Leads 61 from individual columns 31, die cast as previously illustrated, are now joined, via additional leads 61, to other circuit elements. These leads may be on top of the plate 25, shown as 61, or on the bottom of the plate as shown in phantom lines as 61a in Figure 11. Thus, in a three-dimensional sense, additional circuit elements are possible. The various interconnections are not shown, but are readily envisaged by one of ordinary skill in the art.

It is further noted that these interconnections are not possible with prior art devices, as not only soldering and flux removal difficulties are encountered, but any peripheral array which uses a soft plate 25 cannot accomplish these means with any assurance of electrical continuity and reliability. The additional benefit of the positive joining of the circuit layers 61 is accomplished such as illustrated in Figure 11 because the column 31 and the locking collar 36 in the casting operation establish excellent contact with the metallized layer. Additional soldering attachment may also be provided as previously discussed, and these soldering attachments are also illustrated in Figure 12 as 61c. Again, an appropriate caution must be exercised so that the excessive flow of the solder does not impair the electrical integrity of each of the solder columns 31 via-a-vis its next neighbor.

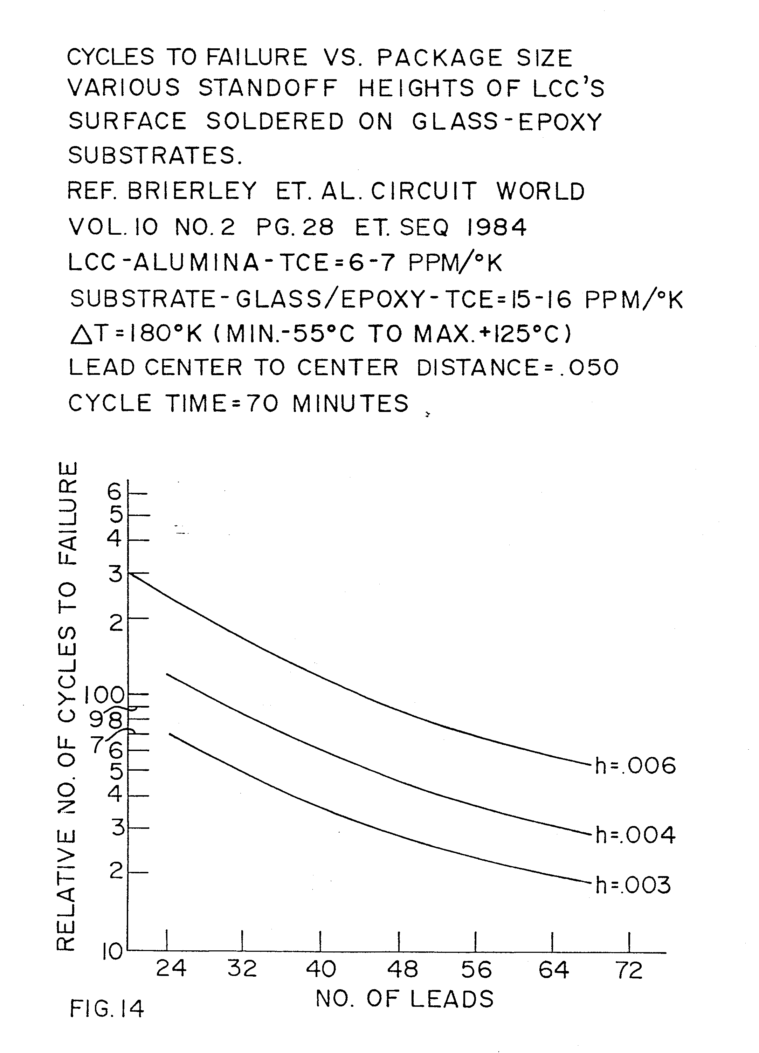

Turning now to Figure 14, this Figure illustrates the typical test used in the art where cycles to failure are measured as it concerns number of leads for each of the package and the stand-off distance.

The cycle time is defined as being the total of seventy minutes of which a prescribed time, as shown in the previously mentioned article by Luke et al, defines the various time periods. At the illustrated conditions, it is evident that as the lead height or the cast column height increases, the reliability also increases. However, this reliability decreases with increasing number of leads. Extrapolating the relative number of cycles versus the number of leads such as up to 180 leads, it is evident that the relative number of cycles to failure are rapidly approaching an intolerable level.

In accordance with the present invention, however, the outstanding relative cycle times are possible for large leadless chip carriers such as having more than 48 leads per chip carrier.

As it is evident from the above description, especially from Figure 14, the failures associated with the thermal and mechanically induced fatigue strains in the solder joints are a severe problem for large leadless ceramic chip carriers. These problems become especially severe when the chip carriers are thereafter joined to the printed circuit board having a different thermal coefficient of expansion. Moreover, the low yield points of tin-lead solder alloys when temperature cycled cause the solder joints to be subjected to plastic strain. The present device is, therefore, provided to accommodate the combination of strains encountered in large leadless chip carriers which are mounted on a printed circuit board having a different thermal coefficient of expansion. These mounting differences are overcome because of the thin microinterconnections provided by the compliant interconnection arrays of the various compliancy types, such as shown in Figures 3a, 5a and 5b. These interconnection arrays are sufficiently flexible under the conditions to provide attractive properties far beyond those expected by soldering techniques heretofore proposed. Because of the precision casting with great detail for the interconnection, the consistency of the center-to-center spacing distances have also been improved. Thus, the electrical continuity between these solder joints are considerably improved because of the excellent coplanarity, solder joint formation, solder control, as well as solder alloy combinations which are possible for the interconnections. Column 31 tip caps 60 as shown in Figure 9 provide for especially desirable combinations which at the same time allow precise fillet and fillet alloy combinations for stage-wise or simultaneous joining of the chip carriers to the printed circuit boards.

It has also been found that increases in solder volume are not necessary to achieve the connections as long as the appropriate coplanarity and vertical placement of the solder column to be joined, such as 31, is maintained with proper fillet formation achieved by proper deposition of solder paste or solder caps and proper flux removal.

The joining techniques also lend themselves to rapid solidification rates because the amount of thermal mass involved in the typical soldering operation such as shown herein can be readily controlled by fast chilling. Hence, proper metallurgical practice may also be readily followed.

In addition to the above rapid solidification, other steps may be employed such as selecting appropriately modified noneutectic alloys. These alloys could be such as 60/40 tin-lead alloys, or any other modifications thereof. Needless to say, this modification complicates it and makes it more expensive to obtain a solder joint, but may be necessary in the circumstances where more severe demands are imposed on the solder connection of the chip carrier to the printed circuit board.

In view of the above, it is now possible to obtain for an equivalent solder joint distance manifold improvements from those previously reported in the prior art. These manifold improvements are obtained with greater reliability, precision and coplanarity without increasing to any substantial degree or, in fact, decreasing the solder volume at the solder column 31 and chip carrier interface.

These microcast columns, e.g., 31, are cast at a fairly high cycle rate in a continuous operation. The assembly of the chip carrier with the device may also be done with great reliability. It is especially noteworthy that the improvement can be achieved mounting these carriers with tighter lead spacing such as from 0.50 inches (1.270 mm) and even down to 0.20 inches (0.508 mm) centerline lead spacings.

These advantages have been obtained with reduced lead inductance, with a reduced thermal mass, substantially with no lead damage in the assembly, and with great reliability in the surface attachment of the solder columns to respective metallization components.

The added flexibility and compliancy which is obtained by the present device is far in excess of that obtainable with prior art devices without sacrifice of fatigue life or thermal mechanical properties experienced with prior art devices. In addition, these benefits are obtained without the prior art disadvantages such as employment of controlled expansion, and printed circuit boards which are relatively heavy, expensive, and which require thick film screening processing.

Although a .020 inch (0.508 mm) minimum space is considered acceptable for good cleaning of leadless surface mounted chip carriers, the device of .030 inch (0.762 mm) gap height has provided, in the present configuration with plate 25 present, generous space for cleaning and rinsing these solder joined assemblies. Even smaller gaps are believed to be sufficient to obtain the precision cleaning necessary in these devices.

The support plate 25 onto which the solder columns are cast is generally of a dielectric nature equivalent to at least a clay-coated paper. The dielectric nature of the plate must be maintained so as to obtain the electrical integrity of each of the solder columns during the operation of the device. The plate 25 material, therefore, must also be compatible with the casting and reflow soldering temperatures and techniques and inert to the board cleaning solvents. Moreover, it must be capable of being cleanly punched so as to obtain the necessary definition for the whole pattern and at the same time have a relatively rigid structure to obtain the needed coplanarity.

0150928

CLAIMS:

1. A compliant interconnection device (25a) of the type having a plurality of spaced, individual interconnections (31) extending on both sides of a plate (25), characterised in that the interconnections (31) are lockingly engaged with the plate (25).

2. The interconnection device (25a) of claim 1 characterised in that the plate (25) is of a flexible, nonelastic, dielectric material (12).

3. The interconnection device (25a) of claim 2 characterised in that the plate (25) is of a dielectric material having a dielectric strength at least equivalent to a paper (12) with clay particulate fillers.

4. The interconnection device (25a) of claim 1 characterised in that the interconnections (31) are columnar.

5. The interconnection device (25a) of claim 1 characterised in that the interconnections (31) include first columnar portions (31a) on each side of the Plate (25) and a vertically offset second columnar portion (31b) extending on both sides of the plate and connected to the first columnar portions (31a) by member (31e) normal to the columnar portions (31a, 31b).

6. The interconnection device (25a) of claim 1 characterised in that the interconnections (31) include first and second vertically offset columnar portions (31a, 31b) joined by a member (31e) extending normal thereto.

7. The interconnection device (25a) of claim 1 characterised by the interconnections (31) being spaced in from the edges of the plate (25) and further a plurality of apertures (15) are provided in the plate (25) interior of the interconnections (31).

8. The interconnection device (25a) of claim 1 characterised by the interconnections (31) comprising a grid array (37) interior to the edges of the plate (25).

9.  The interconnection device (25a) of claim 1, 3, 4, 5 or 6 characterised by the interconnections (31) being cast solder columns.

10.  The interconnection device (25a) of claim 1 characterised in that the interconnections (31) are positioned around the periphery of the plate (25) and one or more columns (37) of heat dissipating material are positioned interior to the interconnections (31).

11.  The interconnection device (25a) of claim 9 characterised by a free end (31d) of at least one solder column (31) extending beyond the free end (31d) of another solder column (31).

12.  The interconnection device (25a) of claim 3 characterised by the plate (25) including electrical circuitry (61) thereon extending to and electrically interconnecting at least two interconnections (31).

13.  The interconnection device (25a) of claim 1 characterised in that the plate (25) includes coregistry means (32,33a) for alignment of the interconnections (31) with circuit elements (26,27) between which the device (25a) may be positioned.

14.  A method for making a compliant interconnection device (25a) of the type having a plurality of spaced, individual solder columns (31) extending through a plate (25) and as claimed in claim 1, characterised by the steps of:

a.  punching a plurality of apertures (15) in a dielectric plate (25);

b.   casting through said apertures solder columns (31) lockingly engaging the plate (25);

c.   chilling the solder columns (31); and

d.   ejecting said solder columns (31) from a casting die (17).

15.   The method of claim 14 characterised by the additional step of depositing solder paste on each free end (31c,31d) of each solder column (31) for soldering said solder columns (31) to circuit elements (26,27).

16.   The method of claim 14 characterised by casting each of the solder columns (31) with a high temperature solder.

17.   The method of claim 14 characterised by the additional step of shearing the cast solder columns (31) at the bottom (31d) thereof.

18.   The method of claim 14 characterised by the additional step of shearing the cast solder columns (31) at both the top (31c) and bottom (31d) for coplanarity between each of the top and bottom surfaces (31c,31d) of the solder columns (31).

19.   The method of claim 14 characterised by casting each of the solder columns (31) with a solder composition of 95 percent lead - 5 percent tin by weight.

20.   A circuit element comprising a printed circuit board (27) having a plurality of circuit pads (30) on a surface thereof, and an interconnection device as claimed in claim 1 comprising a plurality of interconnections (31) soldered to the circuit pads (30), characterised in that the plurality of interconnections (31) comprise individual solder columns (31) in compliant locking securement with a plate (25) and being substantially perpendicular thereto and to each circuit pad (30) and with free ends (31c,31d) on each solder column (31) being substantially coplanar with respect to each circuit pad (30).

21. An assembly including a leadless chip carrier (26) having circuit pads (53) on one surface and an interconnection device as claimed in claim 1 comprising a plurality of interconnections (31) soldered to the circuit pads (53), characterised in that the plurality of interconnections (31) comprise individual, elongated solder columns (31) in compliant locking securement with a plate (25).

22. A microinterconnection casting method characterised by the steps of:

a. maintaining a casting nozzle (17a) at a temperature in a liquidus region of a casting alloy with respect to a phase diagram thereof;

b. maintaining at substantially the same temperature a plurality of conduits (50c) in the casting nozzle (17a) and from the casting nozzle (17a) to a casting die (16) comprising first and second die plates (51,17), wherein said conduits (50c) are in coregistry with a corresponding number of conduits (50c) in a first die plate (51), and wherein said first die plate (51) is movable relative to the casting nozzle (17a);

c. maintaining said second die plate (17) separate and removably positioned with respect to the first die plate (51), said second die plate (17) having a corresponding number of conduits (50c) in the first die plate (51) and the casting nozzle (17a) conduits (50c).

d. engaging, between the first and second die plates (51,17), a temporary die plate (25) having apertures (15) corresponding to each of the conduits (50c) in the first and second die plates (51,17).

e. extruding through said conduits (50c) and apertures (15) said casting alloy to form cast interconnections (31) lockingly engaging the temporary die plate (25);

f. sliding the first, second and temporary die plates (51,17,25) as a unit relative to the conduits (50c) in the casting nozzle (17a) and thereby shearing the cast interconnections (31) at the interface between the casting nozzle (17a) and first die plate (51); and

g. disengaging the first die plate (51) from the second die plate (17) and ejecting therefrom the temporary die plate (25).

23. The method of claim 22 further characterised in that the second die plate (17) comprises first and second die sections (52,53) with the first die section (52) defining the top of the interconnections lockingly engaged to the temporary die plate (25) and wherein the second die section (53) includes heat risers relative to the first die section (52) and wherein the second die section (53) is movable relative to the first die section (52), providing the step of shearingly disengaging the heat risers from the first die section (52), and means (50) for ejecting the interconnections (31) from the first die section (52).

24. An assembly including a leadless chip carrier (26) having circuit pads (53) on one surface, a printed circuit board (27) having circuit pads (30) on one surface and an interconnection device as claimed in claim 1 comprising a plurality of interconnections (31) extending between the carrier 26 and the board 27 and electrically connecting the pads (53) on the carrier (26) to the pads (30) on the board (27), characterised in that the plurality of interconnections (31) comprise individual, elongated solder columns (31) in compliant locking securement with a plate (25) located intermediate the carrier (26) and board (27).

0150928

FIG. 1

FIG. 2

FIG. 2a

26

26

27

FIG. 2b

31

3a

25a

31

27

35

26

32

34

34

53

31

25a

3a

25

31

30

3a

33a

27

FIG.3

**FIG. 3a**

31c

31

36

36a

25

36d

36b

36

31d

25a

37

15

25a

25

**FIG. 4**

31

31

.050 TYP. NON CUMULATIVE

FIG. 5

5a

5a

5a

15

15

15

15

25a

31a

31a

25

FIG. 5a

31a

31a

31a

31e

31e

31b

25

31a

31a

31e

36

36b

31b

31a

25

FIG. 5b

FIG.6

FIG.6a

FIG.6b

FIG.6c

FIG. 7

FIG. 8

FIG. 9

FIG. 10

0150928

FIG. 11

FIG. 12

TIN/LEAD PHASE DIAGRAM     FIG. 13

CYCLES TO FAILURE VS. PACKAGE SIZE
VARIOUS STANDOFF HEIGHTS OF LCC'S
SURFACE SOLDERED ON GLASS-EPOXY
SUBSTRATES.
REF. BRIERLEY ET. AL. CIRCUIT WORLD
VOL. IO NO. 2 PG. 28 ET. SEQ 1984
LCC-ALUMINA-TCE=6-7 PPM/°K
SUBSTRATE-GLASS/EPOXY-TCE=15-16 PPM/°K
$\triangle T = 180°K$ (MIN.-55°C TO MAX.+125°C)
LEAD CENTER TO CENTER DISTANCE=.050
CYCLE TIME=70 MINUTES

FIG. 14